# EUROPEAN PATENT SPECIFICATION

(11) **EP 4 120 095 B1**
(45) Date of publication and mention of the grant of the patent: **04.09.2024**
(21) Application number: 22753576.2
(22) Date of filing: 23.03.2022
(51) Int. Cl.: G06F 16/16, G06F 3/01

(54) **METHOD AND APPARATUS FOR GENERATING VIBRATION DESCRIPTION FILE, AND DEVICE AND READABLE STORAGE MEDIUM**
VERFAHREN UND VORRICHTUNG ZUR ERZEUGUNG EINER VIBRATIONSBESCHREIBUNGSDATEI SOWIE VORRICHTUNG UND LESBARES SPEICHERMEDIUM
PROCÉDÉ ET APPAREIL POUR GÉNÉRER UN FICHIER DE DESCRIPTION DE VIBRATION, ET DISPOSITIF ET SUPPORT DE STOCKAGE LISIBLE

(30) Priority: 20.05.2021 CN 202110553961; 16.06.2021 CN 202110668283
(43) Date of publication of application: 18.01.2023
(73) Proprietor: Honor Device Co., Ltd., Shenzhen, Guangdong 518040 (CN)
(72) Inventor: ZHU, Jianwei, Shenzhen. Guangdong 518040 (CN)
(74) Representative: Epping - Hermann - Fischer
(86) International application number: PCT/CN2022/082416
(87) International publication number: WO 2022/242301

(56) References cited:
- EP-A1- 1 401 185
- EP-A1- 3 343 328
- WO-A1-2020/261805
- WO-A2-2008/147622
- CN-A- 110 022 510
- CN-A- 112 269 895
- US-A1- 2007 178 942
- JONGHYUN RYU ET AL: "posVibEditor: Graphical authoring tool of vibrotactile patterns", HAPTIC AUDIO VISUAL ENVIRONMENTS AND GAMES, 2008. HAVE 2008. IEEE INTERNATIONAL WORKSHOP ON, IEEE, PISCATAWAY, NJ, USA, 18 October 2008 (2008-10-18), pages 120 - 125, XP031365062, ISBN: 978-1-4244-2668-3
- ENRIQUEZ M J ET AL: "The hapticon editor: a tool in support of haptic communication research", HAPTIC INTERFACES FOR VIRTUAL ENVIRONMENT AND TELEOPERATOR SYSTEMS, 20 03. HAPTICS 2003. PROCEEDINGS. 11TH SYMPOSIUM ON 22 AND 23 MAR 2003, PISCATAWAY, NJ, USA,IEEE, 1 January 2003 (2003-01-01), pages 356 - 362, XP010637709, ISBN: 978-0-7695-1890-9

## Description

### TECHNICAL FIELD

This application relates to the field of electronic information, and in particular, to a method for generating a vibration description file, and a device.

### BACKGROUND

Currently, linear motors may be basically classified into X-axis linear motors and Z-axis linear motors according to different stroke directions. Different types of linear motors require different control methods. In the prior art, a technician writes code to form a vibration description file, and controls a linear motor through the vibration description file.

WO 2008/147622 A2 relates to an electronic handheld device comprising a haptic actuating device configured to actuate haptic effects upon a user; memory configured to store software that enables the user to modify the haptic effects; and a processor configured to execute the software stored in memory; wherein the haptic actuating device is further configured to play a modified haptic effect when an event associated with the electronic handheld device occurs.

Document JONGHYUN RYU ET AL: "posVibEditor: Graphical authoring tool of vibrotactile patterns", HAPTIC AUDIO VISUAL ENVIRONMENTS AND GAMES. HAVE 2008, PISCATAWAY, NJ, USA relates to an authoring tool, posVibEditor, for quick and easy design of vibrotactile patterns for vibration motors. The tool supports the drag-and-drop design paradigm so that novice users can easily learn and interact with the tool. Vibration patterns are managed in a database using XML formats in order to improve their reusability and extensibility. The multichannel timeline interface is also developed for designing time-synchronized multiple vibrotactile patterns for multiple vibration motors. In addition, an internal vibration player is incorporated to allow the user to test and evaluate designed patterns immediately. A module for perceptually transparent rendering can guarantee the delivery of perceptually correct vibration effects. The authoring tool is suitable to mobile devices that contain a single vibration motor as well as applications in virtual reality and haptics that frequently employ multiple vibration motors.

EP 3 343 328 A1 relates to a method of authoring haptic effects, comprising receiving a haptic track and a video texture map, the haptic track having haptic data, the haptic data defining operation of a haptic actuator, the video texture map representative of at least one frame of a video, the haptic track associated with the at least one frame of the video, and the video texture map having a plurality of video pixels; and generating haptic data modifiers associated with haptic pixels, each haptic pixel associated with at least one of the video pixels, the haptic data modifiers for modifying at least a portion of the haptic data and modifying operation of the haptic actuator. EP 1 401 185 A1 relates to a method for giving notice of an incoming call in a mobile communication terminal, comprising the steps of setting a vibration pattern in an incoming call notification mode; and when an incoming call is received, generating vibration based on the set vibration pattern.

Document ENRIQUEZ M J ET AL: "The hapticon editor: a tool in support of haptic communication research", HAPTIC INTERFACES FOR VIRTUAL ENVIRONMENT AND TELEOPERATOR SYSTEMS. HAPTICS 2003, PISCATAWAY, NJ, USA relates to haptic icons, or "hapticons", as brief programmed forces applied to a user through a haptic interface, with the role of communicating a simple idea in manner similar to visual or auditory icons. The design and implementation of an innovative software tool and graphical interface for the creation and editing of hapticons are presented. The tool's features include various methods for creating new icons including direct recording of manual trajectories and creation from a choice of basis waveforms; novel direct-manipulation icon editing mechanisms, integrated playback and convenient storage of icons to file.

### SUMMARY

This application provides a method and an apparatus for generating a vibration description file, a device, and a readable storage medium, and is intended to resolve the problem of generating a vibration description file.

The invention is set out in the appended claims.

To achieve the foregoing objective, this application provides the following technical solutions:
A first aspect of this application provides a method for generating a vibration description file, applicable to an electronic device. The electronic device includes a linear motor and a display. The method includes the following steps: presenting, by the display of the electronic device, a first interface, where the first interface displays an obtained vibration waveform, obtaining an adjustment instruction for the vibration waveform, generating an adjusted vibration waveform by applying the adjustment instruction for the vibration waveform on the obtained vibration waveform, generating the vibration description file based on the adjusted vibration waveform, and controlling vibration of the linear motor using the vibration description file. Compared to a vibration description file obtained through programming, the vibration description file generated according to the method described above has higher efficiency with a lower technical threshold.

The generating the vibration description file includes: generating the vibration description file in response to that vibration parameters of the adjusted vibration waveform do not exceed a preset adjustment limit value, so as to protect a to-be-controlled linear motor from being damaged.

Optionally, the obtained vibration waveform is obtained by: generating the vibration waveform according to vibration characteristics of an application; or using a waveform selected from pre-configured scene vibration sense waveforms as the vibration waveform; or receiving the vibration waveform from an external source; or invoking a pre-configured vibration waveform which is used as a template. Regardless of the manner in which the vibration waveform is provided, a user does not have to design the waveform from scratch, so that it can bring great convenience for the user, and the technical threshold is greatly lowered.

Optionally, the generating the vibration description file includes: generating a dynamic description file in response to an adjustment instruction for the vibration waveform received from an external source, where the dynamic description file is used for controlling vibration of the linear motor according to vibration parameters in the dynamic description file in a case that an interruption event occurs, so as to mitigate interference of the vibration to the interruption event.

Optionally, the generating the vibration description file further includes: responding to the vibration waveform generated according to the vibration characteristics of the application; generating a static description file according to the adjustment instruction for the vibration waveform selected from the pre-configured scene vibration sense waveforms, where the static description file is used for controlling the vibration of the linear motor according to vibration parameters in the static description file in a case that no interruption event occurs.

Optionally, types of the vibration parameters indicated by the dynamic description file are a subset of types of the vibration parameters indicated by the static description file, so as to reduce the cost of generating the dynamic description file.

Optionally, the generating an adjusted vibration waveform includes: displaying, in response to an adjustment instruction for the vibration waveform on an interaction interface, the adjusted vibration waveform. The efficiency of generating the vibration description file can be further improved by applying the interaction interface, and a better user experience is provided. Optionally, the displaying, in response to an adjustment instruction for the vibration waveform on an interaction interface, the adjusted vibration waveform includes: displaying, in response to a preset operation instruction for an adjustment point on the vibration waveform displayed on the interaction interface, the adjustment point on the vibration waveform; and displaying, in response to a dragging instruction for the adjustment point in an adjustment mode for a first vibration parameter, a vibration waveform after the first vibration parameter is adjusted, where the first vibration parameter includes an amplitude and/or a frequency. The operation of the adjustment point is easy to implement, which may bring more convenience for the user.

Optionally, the vibration waveform includes a steady state waveform; the first vibration parameter further includes: a time parameter; and the displaying, in response to a dragging instruction for the adjustment point in an adjustment mode for a first vibration parameter, a vibration waveform after the first vibration parameter is adjusted includes: displaying, in response to a dragging instruction for the adjustment point on a time axis in a time adjustment mode, a vibration waveform after the time parameter is adjusted.

Optionally, the displaying, in response to an adjustment instruction for the vibration waveform on an interaction interface, the adjusted vibration waveform includes: displaying, in response to a dragging instruction for the vibration waveform displayed on the interaction interface, a vibration waveform after the time parameter is adjusted.

Optionally, the method further includes: displaying indication information corresponding to a value of an adjusted parameter on the interaction interface. The indication information can make the value of the adjusted parameter more intuitive, which is beneficial to improving the user experience.

Optionally, the generating an adjusted vibration waveform includes: superimposing a plurality of waveforms in response to a superimposition instruction, and generating the adjusted vibration waveform of a superimposed waveform, where the plurality of waveforms are at least a part of the vibration waveform. A plurality of vibration effects are presented and expanded through superimposition, which can support the superimposition of vibration effects of a plurality of scenes, so that the vibration feeling of the user is enriched.

Optionally, the superimposition instruction includes: an instruction for dragging the plurality of waveforms to a time range overlapping state.

A second aspect of this application provides an electronic device, including:
one or more processors, a display; and
a memory, storing a program, where
the electronic device is configured to carry out the method for generating a vibration description file according to the first aspect of this application.

### BRIEF DESCRIPTION OF DRAWINGS

FIG. 1a is an example diagram of a structure and an application of an X-axis linear motor;
FIG. 1b is an example diagram of a structure and an application of a Z-axis linear motor;
FIG. 2 is a schematic structural diagram of an electronic device according to an embodiment of this application;
FIG. 3a is an example diagram of a software architecture to which a method for adjusting a vibration waveform of a linear motor is applied according to an embodiment of this application;
FIG. 3b is an example diagram of a flow of implementing functions of the software architecture shown in FIG. 3a;
FIG. 4 is a flowchart of a method for generating a vibration description file according to an embodiment of this application;
FIG. 5 is an example diagram of an interaction interface for generating a vibration description file according to an embodiment of this application; and
FIG. 6 is a schematic structural diagram of an apparatus for generating a vibration description file according to an example not according to the invention and present for illustrative purposes only.

### DESCRIPTION OF EMBODIMENTS

The technical solutions in the embodiments of this application are described below with reference to the accompanying drawings in the embodiments of this application. Obviously, the described embodiments are some rather than all of the embodiments of this application. All other embodiments obtained by a person of ordinary skill in the art based on the embodiments of this application without creative efforts shall fall within the protection scope of this application.

In this application, the terms "include", "comprise", or any other variant are intended to cover non-exclusive include, so that a process, a method, an article, or a device including a series of elements not only includes such elements, but also includes other elements not explicitly listed, or may further include elements inherent in the process, the method, the article, or the device. Unless otherwise specified, an element limited by "include a/an..." does not exclude other same elements existing in the process, the method, the article, or the device that includes the element.

A linear motor is arranged in an electronic device, and is configured to vibrate to enable the electronic device to output vibration sense. In different scenarios of the electronic device, the linear motor is controlled to vibrate to produce different vibration effects for a user to perceive the vibration sense, so as to prompt the user or give feedback on an operation of the user. The vibration effects are specifically as follows:
1. Different service scenarios (for example, time alerting, information receiving, incoming calls, alarm clocks, and games) may correspond to different vibration effects.
2. Feedback to touch. For example, touch operations performed on different applications (for example, photo taking and audio playing) may correspond to different vibration effects. Touch operations performed on different regions of a display screen may also correspond to different vibration effects.

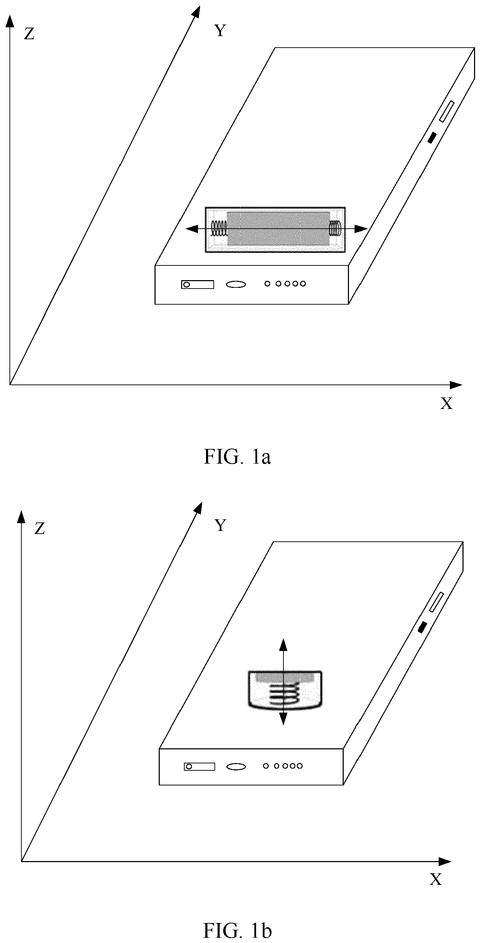

Linear motors commonly used in electronic devices include X-axis linear motors (also referred to as square or lateral linear motors) and Z-axis linear motors (also referred to as circular or longitudinal linear motors). FIG. 1a shows an example of a structure and an application of an X-axis linear motor, and FIG. 1b shows an example of a structure and an application of a Z-axis linear motor.

As shown in FIG. 1a, the X-axis linear motor is in a shape of a long bar or a square. Assuming that an X-axis is a horizontal axis, a Y-axis is a vertical axis, and a Z-axis is a vertical axis perpendicular to the X-axis and the Y-axis, according to a placement direction, a mover of the X-axis linear motor can move in the X-axis or Y-axis direction with a longer stroke. The X-axis linear motor is mounted along the X-axis in the electronic device, and can provide vibration sense in the X-axis direction. If the X-axis linear motor is mounted along the Y-axis, vibration sense in the Y-axis direction can be provided.

As shown in FIG. 1b, the Z-axis linear motor is in a shape of a cylinder, and a mover can move in the Z-axis direction. The Z-axis linear motor is arranged in the electronic device, and can provide vibration sense along a thickness direction of the electronic device.

A vibration description file is one of key elements to control vibration of the linear motor. The vibration description file is used for describing a vibration waveform of the linear motor. The vibration waveform indicates various vibration parameters, such as an amplitude and a frequency during the vibration of the motor. It can be seen that a function of the vibration description file is to indicate how the motor vibrates. Therefore, the user may configure an expected vibration effect through the vibration description file.

Currently, the vibration description file is generated by a technician through writing code, which has a high technical threshold and low efficiency, and also brings the following problems:
With the development of terminals, there is a demand to expand the function of the terminals and improve the user experience of the terminals. The vibration function has room to expand, and the expansion of the vibration function is beneficial to improving the user experience. For example, the linear motor is controlled to vibrate with music during music playback, or the linear motor is controlled to vibrate with shots in a scene such as shooting in a game.

Because of the complexity and diversity of service scenarios of the terminals, it is difficult for the technician to prepare a vibration description file in advance for each service scenario. In addition, because there is a high technical threshold for writing a vibration description file, it is difficult for a terminal user to customize a vibration description file required for a service scenario in this manner.

It can be seen that a current manner for obtaining a vibration description file has become a constraint on expanding the vibration function and improving the user experience.

Therefore, embodiments of this application provide a method and electronic device for generating a vibration file, so as to reduce the technical threshold for obtaining a vibration description file, improve the efficiency of obtaining the vibration description file, and mitigate the contradiction among obtaining the vibration description file, expanding the vibration function, and improving the user experience.

The method for generating a vibration file according to the embodiments of this application are applicable to an electronic device in which a linear motor is arranged. The electronic device in which the linear motor is arranged may be a mobile phone, a tablet computer, a desktop computer, a laptop computer, a notebook computer, an ultra-mobile personal computer (Ultra-mobile Personal Computer, UMPC), a handheld computer, a netbook, a personal digital assistant (Personal Digital Assistant, PDA), a wearable electronic device, a smart watch, or the like.

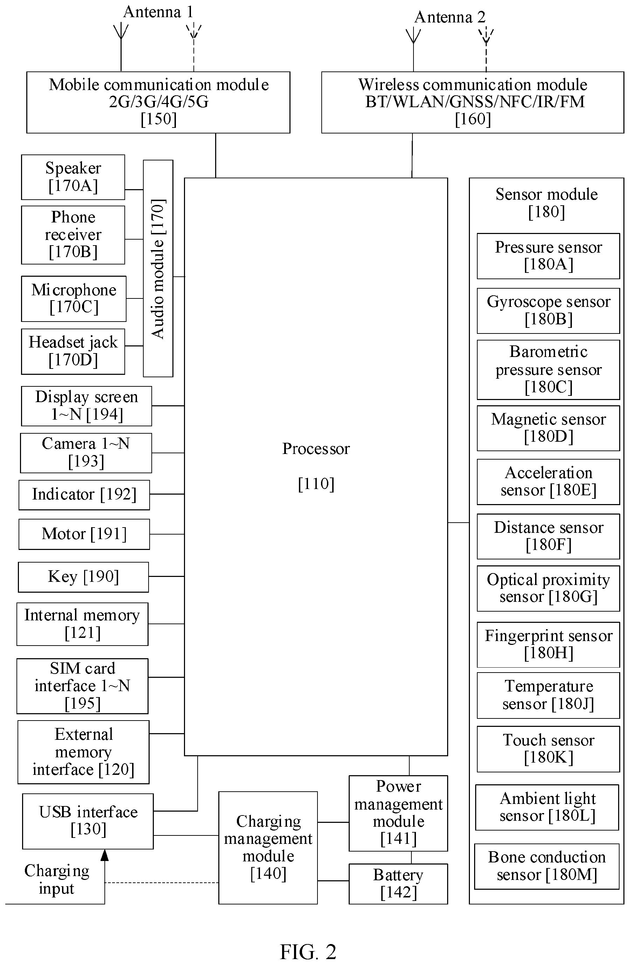

The electronic device shown in FIG. 2 includes: a processor 110, an external memory interface 120, an internal memory 121, a universal serial bus (universal serial bus, USB) interface 130, a charging management module 140, a power management module 141, a battery 142, an antenna 1, an antenna 2, a mobile communication module 150, a wireless communication module 160, an audio module 170, a speaker 170A, a phone receiver 170B, a microphone 170C, a headset jack 170D, a sensor module 180, a key 190, a motor 191, an indicator 192, a camera 193, a display screen 194, a subscriber identification module (subscriber identification module, SIM) card interface 195, and the like. The sensor module 180 may include a pressure sensor 180A, a gyroscope sensor 180B, a barometric pressure sensor 180C, a magnetic sensor 180D, an acceleration sensor 180E, a distance sensor 180F, an optical proximity sensor 180G, a fingerprint sensor 180H, a temperature sensor 180J, a touch sensor 180K, an ambient light sensor 180L, a bone conduction sensor 180M, and the like.

It can be understood that a schematic structure in this embodiment does not constitute a specific limitation on the electronic device. In some other embodiments, the electronic device may include more or fewer components than those shown in the figure, or some components may be combined, or some components may be split, or a different component deployment may be used. The components shown in the figure may be implemented by hardware, software, or a combination of software and hardware.

The processor 110 may include one or more processing units. For example, the processor 110 may include an application processor (application processor, AP), a modem processor, a graphics processing unit (graphics processing unit, GPU), an image signal processor (image signal processor, ISP), a controller, a video codec, a digital signal processor (digital signal processor, DSP), a baseband processor, and/or a neural-network processing unit (neural-network processing unit, NPU). Different processing units may be independent devices, or may be integrated into one or more processors.

The controller may be a nerve center and a command center of the electronic device. The controller may generate an operating control signal according to an instruction operation code and a timing signal, to complete control of fetching and executing an instruction.

A memory may be further configured in the processor 110, and is configured to store instructions and data. In some embodiments, the memory in the processor 110 is a cache. The memory may store an instruction or data that has just been used or cyclically used by the processor 110. If the processor 110 needs to use the instruction or the data again, the processor may directly invoke the instruction or the data from the memory, to avoid repeated access and reduce a waiting time of the processor 110, thereby improving system efficiency.

In some embodiments, the processor 110 may include one or more interfaces. The interface may include an inter-integrated circuit (inter-integrated circuit, I2C) interface, an inter-integrated circuit sound (inter-integrated circuit sound, I2S) interface, a pulse code modulation (pulse code modulation, PCM) interface, a universal asynchronous receiver/transmitter (universal asynchronous receiver/transmitter, UART) interface, a mobile industry processor interface (mobile industry processor interface, MIPI), a general-purpose input/output (general-purpose input/output, GPIO) interface, a subscriber identity module (subscriber identity module, SIM) interface, and/or a universal serial bus (universal serial bus, USB) interface, and the like.

The I2C interface is a two-way synchronization serial bus, and includes a serial data line (serial data line, SDA) and a serial clock line (derail clock line, SCL). In some embodiments, the processor 110 may include a plurality of groups of I2C buses. The processor 110 may be coupled to the touch sensor 180K, a charger, a flash light, the camera 193, and the like by using different I2C bus interfaces. For example, the processor 110 may be coupled to the touch sensor 180K by using the I2C interface, so that the processor 110 communicates with the touch sensor 180K by using the I2C bus interface, to implement a touch function of the electronic device.

The I2S interface may be used for audio communication. In some embodiments, the processor 110 may include a plurality of groups of I2S buses. The processor 110 may be coupled to the audio module 170 by using the I2S bus, to implement communication between the processor 110 and the audio module 170. In some embodiments, the audio module 170 may transfer an audio signal to the wireless communication module 160 by using the I2S interface, to implement a function of answering a call by using a Bluetooth headset.

The PCM interface may also be used for audio communication, and sampling, quantization, and encoding of an analog signal. In some embodiments, the audio module 170 may be coupled to the wireless communication module 160 by using the PCM bus interface. In some embodiments, the audio module 170 may also transfer an audio signal to the wireless communication module 160 by using the PCM interface, to implement a function of answering a call by using a Bluetooth headset. Both the I2S interface and the PCM interface may be used for audio communication.

The UART interface is a universal serial data bus, and is used for asynchronous communication. The bus may be a two-way communication bus. The bus converts to-be-transmitted data between serial communication and parallel communication. In some embodiments, the UART interface is generally configured to connect the processor 110 to the wireless communication module 160. For example, the processor 110 communicates with a Bluetooth module in the wireless communication module 160 by using a UART interface, to implement a Bluetooth function. In some embodiments, the audio module 170 may transfer an audio signal to the wireless communication module 160 by using a UART interface, to implement a function of playing music by using a Bluetooth headset. The MIPI interface may be configured to connect the processor 110 to a peripheral device such as the display screen 194 and the camera 193. The MIPI interface includes a camera serial interface (camera serial interface, CSI), a display serial interface (display serial interface, DSI), and the like. In some embodiments, the processor 110 communicates with the camera 193 by using the CSI interface, to implement a photographing function of the electronic device. The processor 110 communicates with the display screen 194 by using a DSI interface, to implement a display function of the electronic device.

The GPIO interface may be configured through software. The GPIO interface may be configured to transmit a control signal, or may be configured to transmit a data signal. In some embodiments, the GPIO interface may be configured to connect the processor 110 to the camera 193, the display screen 194, the wireless communication module 160, the audio module 170, the sensor module 180, and the like. The GPIO interface may also be configured as an I2C interface, an I2S interface, a UART interface, an MIPI interface, or the like.

The USB interface 130 is an interface that conforms to a USB standard specification, and may be specifically a mini USB interface, a micro USB interface, a USB Type C interface, or the like. The USB interface 130 may be configured to connect to the charger to charge the electronic device, or may be used for data transmission between the electronic device and a peripheral device, or may be configured to connect to a headset, to play audio by using the headset. The interface may alternatively be configured to connect to another electronic device such as an AR device.

It can be understood that an interface connection relationship between the modules illustrated in this embodiment is merely an example for description, and does not constitute a limitation on a structure of the electronic device. In some other embodiments of this application, the electronic device may alternatively use an interface connection manner different from that in the foregoing embodiment, or use a combination of a plurality of interface connection manners.

The charging management module 140 is configured to receive a charging input from a charger. The charger may be a wireless charger or a wired charger. In some embodiments of wired charging, the charging management module 140 may receive a charging input of a wired charger by using the USB interface 130. In some embodiments of wireless charging, the charging management module 140 may receive a wireless charging input by using a wireless charging coil of the electronic device. The charging management module 140 may supply power to the electronic device by using the power management module 141 while charging the battery 142.

The power management module 141 is configured to connect to the battery 142, the charging management module 140, and the processor 110. The power management module 141 receives an input of the battery 142 and/or the charging management module 140, to supply power to the processor 110, the internal memory 121, the display screen 194, the camera 193, the wireless communication module 160, and the like. The power management module 141 may be further configured to monitor parameters such as a battery capacity, a battery cycle count, and a battery state of health (electric leakage and impedance). In some other embodiments, the power management module 141 may alternatively be configured in the processor 110. In some other embodiments, the power management module 141 and the charging management module 140 may further be configured in the same device.

A wireless communication function of the electronic device may be implemented by using the antenna 1, the antenna 2, the mobile communications module 150, the wireless communications module 160, the modem processor, the baseband processor, and the like.

The antenna 1 and the antenna 2 are configured to transmit or receive an electromagnetic wave signal. Each antenna in the electronic device may be configured to cover one or more communication frequency bands. Different antennas may also be multiplexed to improve utilization of the antennas. For example, the antenna 1 may be multiplexed as a diversity antenna of a wireless local area network. In some other embodiments, the antenna may be used in combination with a tuning switch.

The mobile communication module 150 may provide a solution to wireless communication such as 2G/3G/4G/5G applied to the electronic device. The mobile communication module 150 may include at least one filter, a switch, a power amplifier, a low noise amplifier (low noise amplifier, LNA), and the like. The mobile communication module 150 may receive an electromagnetic wave through the antenna 1, perform processing such as filtering and amplification on the received electromagnetic wave, and transmit a processed electromagnetic wave to the modem processor for demodulation. The mobile communication module 150 may further amplify a signal modulated by the modem processor, and convert the signal into an electromagnetic wave for radiation through the antenna 1. In some embodiments, at least some functional modules of the mobile communication module 150 may be configured in the processor 110. In some embodiments, at least some functional modules of the mobile communication module 150 and at least some modules of the processor 110 may be configured in the same device.

The modem processor may include a modulator and a demodulator. The modulator is configured to modulate a to-be-sent low-frequency baseband signal into a medium-high-frequency signal. The demodulator is configured to demodulate a received electromagnetic wave signal into a low-frequency baseband signal. Then, the demodulator transmits the demodulated low-frequency baseband signal to the baseband processor for processing. The low-frequency baseband signal is processed by the baseband processor and then transmitted to an application processor. The application processor outputs a sound signal through an audio device (which is not limited to the speaker 170A, the phone receiver 170B, and the like), or displays an image or a video through the display screen 194. In some embodiments, the modem processor may be an independent device. In some other embodiments, the modem processor may be independent of the processor 110, and the modem processor and the mobile communication module 150 or another functional module may be configured in the same component.

The wireless communication module 160 may provide a solution for wireless communication including a wireless local area network (wireless local area network, WLAN) (such as a wireless fidelity (wireless fidelity, Wi-Fi) network), Bluetooth (bluetooth, BT), and a global navigation satellite system (global navigation satellite system, GNSS), frequency modulation (frequency modulation, FM), a near field communication (near field communication, NFC) technology, an infrared (infrared, IR) technology, and the like to be applied to the electronic device. The wireless communications module 160 may be one or more devices into which at least one communication processing module is integrated. The wireless communication module 160 receives an electromagnetic wave by using the antenna 2, performs frequency modulation and filtering processing on an electromagnetic wave signal, and sends a processed signal to the processor 110. The wireless communication module 160 may alternatively receive a to-be-sent signal from the processor 110, perform frequency modulation and amplification on the to-be-sent signal, and convert the signal into an electromagnetic wave for radiation by using the antenna 2.

In some embodiments, in the electronic device, the antenna 1 is coupled to the mobile communication module 150, and the antenna 2 is coupled to the wireless communication module 160, so that the electronic device may communicate with a network and another device by using a wireless communication technology. The wireless communication technology may include a global system for mobile communications (global system for mobile communications, GSM), a general packet radio service (general packet radio service, GPRS), code division multiple access (code division multiple access, CDMA), wideband code division multiple access (wideband code division multiple access, WCDMA), time-division code division multiple access (time-division code division multiple access, TD-SCDMA), long term evolution (long term evolution, LTE), BT, GNSS, WLAN, NFC, FM, and/or IR technologies, and the like. The GNSS may include a global positioning system (global positioning system, GPS), a global navigation satellite system (global navigation satellite system, GLONASS), a Beidou navigation satellite system (beidou navigation satellite system, BDS), a quasi-zenith satellite system (quasi-zenith satellite system, QZSS), and/or satellite-based augmentation systems (satellite based augmentation systems, SBAS).

The electronic device implements a display function by using the GPU, the display screen 194, the application processor, and the like. The GPU is a microprocessor for image processing, and is connected to the display screen 194 and the application processor. The GPU is configured to perform mathematical and geometric calculation, and is configured to render graphics. The processor 110 may include one or more GPUs, and execute program instructions to generate or change display information.

The display screen 194 is configured to display an image, a video, and the like. The display screen 194 includes a display panel. The display panel may be a liquid crystal display (liquid crystal display, LCD), an organic light-emitting diode (organic light-emitting diode, OLED), an active-matrix organic light emitting diode (active-matrix organic light emitting diode, AMOLED), a flex light-emitting diode (flex light-emitting diode, FLED), a mini LED, a micro LED, a micro-OLED, a quantum dot light emitting diode (quantum dot light emitting diodes, QLED), or the like. In some embodiments, the electronic device may include one or N display screens 194, and N is a positive integer greater than 1.

The display screen 194 of the electronic device may display a series of graphical user interfaces (graphical user interfaces, GUIs), which are home screens of the electronic device. Generally, the size of the display screen 194 of the electronic device is fixed and only a limited quantity of controls can be displayed in the display screen 194 of the electronic device. The control is a GUI element, which is a software component included in an application, and is configured to control all data processed by the application and interactions about the data. The user may interact with the control through direct manipulation (direct manipulation) to read or edit information about the application. Generally, the controls may include visual interface elements such as icons, keys, menus, tabs, text boxes, dialog boxes, status bars, navigation bars, and Widgets. For example, in the embodiments of this application, the display screen 194 may display virtual keys.

The electronic device may implement a photographing function by using the ISP, the camera 193, the video codec, the GPU, the display screen 194, the application processor, and the like.

The ISP is configured to process data fed back by the camera 193. For example, during photographing, a shutter is enabled. Light is transferred to a photosensitive element of the camera through a lens, and an optical signal is converted into an electrical signal. The photosensitive element of the camera transfers the electrical signal to the ISP for processing, and therefore, the electrical signal is converted into an image visible to a naked eye. The ISP may also perform algorithm optimization on image noise point, brightness, and skin tone. The ISP may also optimize parameters such as exposure and a color temperature of a photographing scenario. In some embodiments, the ISP may be arranged in the camera 193.

The camera 193 is configured to capture a static image or a video. An optical image of an object is generated through a lens and is projected to the photosensitive element. The photosensitive element may be a charge coupled device (charge coupled device, CCD) or a complementary metal-oxide-semiconductor (complementary metal-oxide-semiconductor, CMOS) phototransistor. The photosensitive element converts an optical signal into an electrical signal, and then transmits the electrical signal to the ISP to convert the electrical signal into a digital image signal. The ISP outputs the digital image signal to the DSP for processing. The DSP converts the digital image signal into an image signal in a standard format such as RGB, YUV, and the like. In some embodiments, the electronic device may include one or N cameras 193, and N is a positive integer greater than 1.

The digital signal processor is configured to process a digital signal, and may further process another digital signal in addition to a digital image signal. For example, when the electronic device performs frequency selection, the digital signal processor is configured to perform Fourier transform and the like on frequency energy.

The video codec is configured to compress or decompress a digital video. The electronic device may support one or more video codecs. In this way, the electronic device may play or record videos in a plurality of encoding formats, for example, moving picture experts group (moving picture experts group, MPEG) 1, MPEG 2, MPEG 3, MPEG 4, and the like.

The NPU is a neural-network (neural-network, NN) computing processor, and quickly processes input information by using a biological neural network structure such as a mode of transmission between human-brain nerve cells, and may further constantly perform self-learning. The NPU may be configured to implement an application such as intelligent cognition of the electronic device, for example, image recognition, facial recognition, voice recognition, text understanding, and the like.

The external memory interface 120 may be configured to connect to an external storage card, for example, a micro SD card, to expand a storage capability of the electronic device. The external storage card communicates with the processor 110 by using the external memory interface 120, so as to implement a data storage function, such as storing a file such as a music or a video in the external storage card.

The electronic device may implement an audio function, for example, music playback or recording, by using the audio module 170, the speaker 170A, the phone receiver 170B, the microphone 170C, the headset jack 170D, the application processor, and the like.

The audio module 170 is configured to convert digital audio information into an analog audio signal output, and is further configured to convert an analog audio input into a digital audio signal. The audio module 170 may be further configured to encode and decode an audio signal. In some embodiments, the audio module 170 may be arranged in the processor 110, or some functional modules of the audio module 170 are arranged in the processor 110.

The speaker 170A, also referred to as a "horn", is configured to convert an audio electrical signal into a sound signal. Music can be listened to or a hands-free call can be answered by using the speaker 170A in the electronic device.

The phone receiver 170B, also referred to as a "receiver", is configured to convert an audio electrical signal into a sound signal. When the electronic device is configured to answer a call or receive voice information, the phone receiver 170B may be put close to a human ear to receive a voice.

The microphone 170C, also referred to as a "mouthpiece" or a "megaphone", is configured to convert a sound signal into an electrical signal. When making a call or sending voice information, a user may make a sound near the microphone 170C through the mouth of the user, to input a sound signal into the microphone 170C. At least one microphone 170C may be arranged in the electronic device. In some other embodiments, two microphones 170C may be arranged in the electronic device, to collect a sound signal and implement a noise reduction function. In some other embodiments, three, four, or more microphones 170C may be alternatively arranged in the electronic device, to collect a sound signal, implement noise reduction, recognize a sound source, implement a directional recording function, and the like.

The headset jack 170D is configured to connect to a wired headset. The headset jack 170D may be a USB interface 130, or may be a 3.5 mm open mobile terminal platform (open mobile terminal platform, OMTP) standard interface, or a cellular telecommunications industry association of the USA (cellular telecommunications industry association of the USA, CTIA) standard interface. The pressure sensor 180A is configured to sense a pressure signal, and may convert the pressure signal into an electrical signal. In some embodiments, the pressure sensor 180A may be arranged on the display screen 194. There are a plurality of types of pressure sensors 180A, for example, a resistive pressure sensor, an inductive pressure sensor, and a capacitive pressure sensor. The capacitive pressure sensor may include at least two parallel plates having conductive materials. When a force is applied to the pressure sensor 180A, the capacitance between electrodes changes. The electronic device determines strength of pressure based on a change of the capacitance. When a touch operation is performed on the display screen 194, the electronic device detects strength of the touch operation by using the pressure sensor 180A. The electronic device may also calculate a position of the touch based on a detection signal of the pressure sensor 180A. In some embodiments, touch operations that are performed on a same touch position but have different touch operation strength may correspond to different operation instructions. For example, when a touch operation whose touch operation strength is less than a first pressure threshold is performed on an SMS message application icon, an instruction for checking an SMS message is executed. When a touch operation whose touch operation strength is greater than or equal to the first pressure threshold is performed on the SMS message application icon, an instruction for creating a new SMS message is executed.

The gyroscope sensor 180B may be configured to determine a motion posture of the electronic device. In some embodiments, an angular velocity of the electronic device around three axes (i.e., x, y, and z axes) may be determined by using the gyroscope sensor 180B. The gyroscope sensor 180B may be used for image stabilization during photographing. For example, when the shutter is pressed, the gyroscope sensor 180B detects an angle at which the electronic device jitters, and calculates, based on the angle, a distance for which a lens module needs to compensate, and allows the lens to cancel the jitter of the electronic device through reverse motion, thereby implementing image stabilization. The gyroscope sensor 180B may also be used in navigation and a motion sensing game scenario.

The barometric pressure sensor 180C is configured to measure barometric pressure. In some embodiments, the electronic device calculates an altitude by using a barometric pressure value measured by the barometric pressure sensor 180C, to assist in positioning and navigation.

The magnetic sensor 180D includes a Hall effect sensor. The electronic device may detect the opening and closing of a flip leather case by using the magnetic sensor 180D. In some embodiments, when the electronic device is a clamshell phone, the electronic device may detect the opening and closing of a flip cover by using the magnetic sensor 180D. Then, according to a detected opening and closing state of the leather case or an opening and closing state of the flip cover, characteristics such as automatic unlocking of the flip cover are set.

The acceleration sensor 180E may detect acceleration values of the electronic device in all directions (generally in three axes). When the electronic device is stationary, a magnitude and a direction of gravity may be detected. The acceleration sensor may be further configured to recognize a posture of the electronic device, and is applied to an application such as switching between landscape orientation and portrait orientation or a pedometer.

The distance sensor 180F is configured to measure a distance. The electronic device may measure a distance through infrared or laser. In some embodiments, in a photographing scenario, the electronic device may measure a distance by using the distance sensor 180F, to implement quick focusing.

The optical proximity sensor 180G may include, for example, a light-emitting diode (LED) and an optical detector such as a photodiode. The light-emitting diode may be an infrared light-emitting diode. The electronic device may emit infrared light by using the light-emitting diode. The electronic device detects infrared reflected light from a nearby object by using the photodiode. When detecting sufficient reflected light, the electronic device may determine that there is an object near the electronic device. When detecting insufficient reflected light, the electronic device may determine that there is no object near the electronic device. The electronic device may detect, by using the optical proximity sensor 180G, that a user holds the electronic device close to an ear to make a call, to automatically turn off the screen for power saving. The optical proximity sensor 180G may be further configured to automatically unlock and lock the screen in a leather case mode and a pocket mode.

The ambient light sensor 180L is configured to sense luminance of ambient light. The electronic device may adaptively adjust luminance of the display screen 194 according to sensed luminance of the ambient light. The ambient light sensor 180L may be further configured to automatically adjust white balance during photo taking. The ambient light sensor 180L may further cooperate with the optical proximity sensor 180G to detect whether the electronic device is in a pocket, so as to prevent an accidental touch.

The fingerprint sensor 180H is configured to collect a fingerprint. The electronic device may implement fingerprint-based unlock, application lock accessing, fingerprint-based photographing, fingerprint-based call answering, and the like by using a feature of the collected fingerprint.

The temperature sensor 180J is configured to detect a temperature. In some embodiments, the electronic device executes a temperature processing policy by using the temperature detected by the temperature sensor 180J. For example, when the temperature reported by the temperature sensor 180J exceeds a threshold, the electronic device reduces performance of a processor near the temperature sensor 180J, to reduce power consumption and implement heat protection. In some other embodiments, when the temperature is lower than another threshold, the electronic device heats the battery 142, to avoid an abnormal shutdown of the electronic device caused by a low temperature. In some other embodiments, when the temperature is lower than still another threshold, the electronic device boosts an output voltage of the battery 142, to avoid an abnormal shutdown caused by a low temperature.

The touch sensor 180K is also referred to as a "touch device". The touch sensor 180K may be arranged on the display screen 194, and the touch sensor 180K and the display screen 194 form a touchscreen. The touch sensor 180K is configured to detect a touch operation performed on or near the touch sensor 180K. The touch sensor may transmit the detected touch operation to the application processor, to determine a touch event type. The touch sensor may provide a visual output related to the touch operation by using the display screen 194. In some other embodiments, the touch sensor 180K may be alternatively arranged on a surface of the electronic device, and is located at a position different from that of the display screen 194.

The bone conduction sensor 180M may obtain a vibration signal. In some embodiments, the bone conduction sensor 180M may obtain a vibration signal of a vibration bone of a human vocal-cord part. The bone conduction sensor 180M may alternatively contact a human pulse, and receive a blood pressure beating signal. In some embodiments, the bone conduction sensor 180M may be alternatively arranged in a headset, to form a bone conduction headset. The audio module 170 may obtain a voice signal through parsing based on the vibration signal of the vibration bone of the vocal-cord part that is obtained by the bone conduction sensor 180M, to implement a voice function. The application processor may parse heart rate information based on the blood pressure beating signal obtained by the bone conduction sensor 180M, to implement a heart rate detection function.

The key 190 includes a power key, a volume key, and the like. The key 190 may be a mechanical key, or a touch-type key. The electronic device may receive a key input, and generate a key signal input related to user setting and function control of the electronic device.

The indicator 192 may be an indicator light, and may be configured to indicate a charging state or a battery change, or may be further configured to indicate a message, a missed call, a notification, or the like.

The SIM card interface 195 is configured to connect to a SIM card. The SIM card may be inserted into the SIM card interface 195 or plugged from the SIM card interface 195, to come into contact with or be separated from the electronic device. The electronic device may support one or N SIM card interfaces, and N is a positive integer greater than 1. The SIM card interface 195 can support a nano SIM card, a micro SIM card, a SIM card, and the like. A plurality of cards may all be inserted into the same SIM card interface 195. The plurality of cards may be of the same type or different types. The SIM card interface 195 may further be compatible with different types of SIM cards. The SIM card interface 195 may also be compatible with an external memory card. The electronic device interacts with a network by using a SIM card, to implement functions such as a call and data communication. In some embodiments, the electronic device uses an eSIM, that is, an embedded SIM card. The eSIM card may be embedded in the electronic device and cannot be separated from the electronic device.

The motor 191 includes at least one of the X-axis linear motor shown in FIG. 1a and the Z-axis linear motor shown in FIG. 1b.

The internal memory 121 is configured to store computer executable program code, and the executable program code includes instructions. The processor 110 runs the instructions stored in the internal memory 121, to perform various function applications and data processing of the electronic device. For example, in this embodiment, the processor 110 generates a vibration description file by executing instructions, apparatuses, or modules stored in the internal memory 121. In another example, the processor 110 selects and adjusts a waveform in response to a signal triggered by a user through an operation received by an interaction interface in the touch screen, and generates a vibration description file based on an adjusted waveform.

The internal memory 121 may include a program storage region and a data storage region. The program storage region may store an operating system, an application program required by at least one function (for example, a sound playback function or an image playing function), and the like. The data storage region may store data (for example, audio data and an address book) created during use of the electronic device. In addition, the internal memory 121 may include a high-speed random access memory, or may include a non-volatile memory such as at least one magnetic disk memory, a flash memory, a universal flash storage (universal flash storage, UFS), and the like. The processor 110 runs the instructions stored in the internal memory 121 and/or the instructions stored in the memory arranged in the processor, to implement various functional applications and data processing of the electronic device.

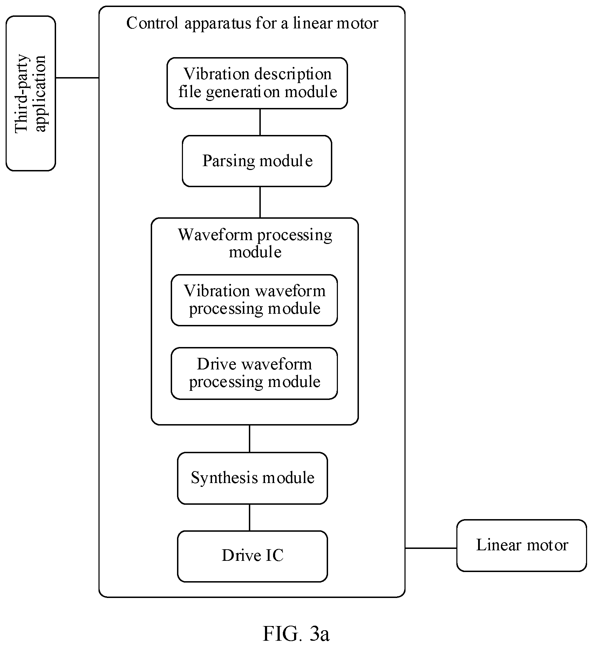

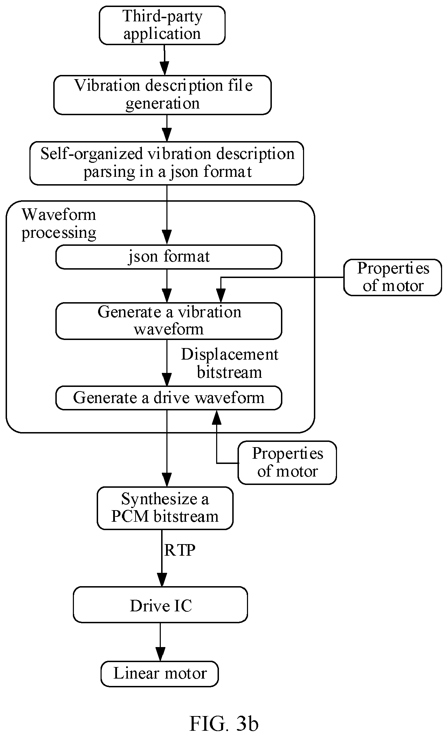

Further, FIG. 3a shows an example of a software architecture to which a technical solution according to an embodiment of this application is applied. With reference to the content of FIG. 3b, it can be learned that:
a vibration description file generation module (capable of interacting with a third-party application) is configured to generate a vibration description file. A parsing module is configured to parse the vibration description file, and obtain a file in a json format for describing a vibration waveform. A waveform processing module is configured to perform waveform processing on the file in the json format. Specifically, a vibration waveform processing module first adopts a synthetic motor displacement algorithm, and generates a vibration waveform in a form of a displacement bitstream according to the file in the json format and properties of a motor, and then a drive waveform processing module performs an inverse solution operation on the vibration waveform and the properties of the motor by using an inverse solution motor voltage drive algorithm, to obtain a drive waveform.

The drive waveform obtained after the waveform processing of the waveform processing module is synthesized by a synthesis module to obtain an audio bitstream in a format such as pulse code modulation (Pulse Code Modulation, PCM), which is transmitted to a drive integrated circuit (Integrated Circuit, IC) by a protocol such as the real-time transport protocol (Real-time Transport Protocol, RTP), and finally acts on a linear motor to control operation of the linear motor.

In combination with the structure of the foregoing electronic device, the software architecture shown in FIG. 3a may be stored in the internal memory 121, and is invoked by the processor 110 to implement a flow described in FIG. 3b. The method for generating a vibration description file in the embodiments of this application is applicable to the vibration description file generation module in FIG. 1a.

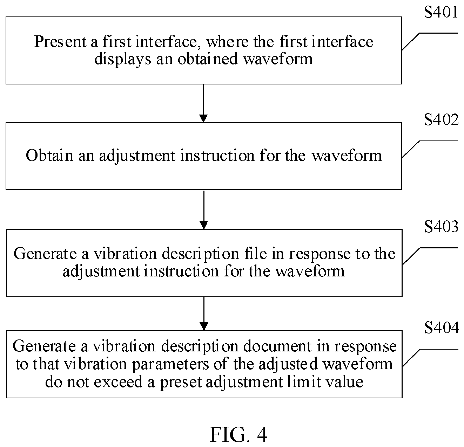

The method for generating a vibration description file in the embodiments of this application is described in detail below. FIG. 4 shows a method for generating a vibration description file according to an embodiment of this application, including the following steps:
S401: Present a first interface, where the first interface displays an obtained waveform. Specifically, the waveform is obtained in the following manners:
1. Generate the waveform according to vibration characteristics of an application.

The vibration characteristics of the application refer to characteristics of an object that can use vibration in the application.

For example, the application may be a multimedia player, the object that can use vibration may be multimedia. Then, the waveform is generated according to characteristics, such as: an envelope, a frequency, an amplitude, a tone, and a rhythm of the multimedia.

It can be understood that a type of the object that can use vibration in various applications may be pre-configured, and the type of object may be received externally, for example, a user-imported audio file is received. 2. Select the waveform from pre-configured scene vibration sense waveforms.

The pre-configured scene vibration sense waveforms include waveforms corresponding to vibration sense in a variety of scenes, for example, a waveform corresponding to vibration sense in a shooting scene in a game, and a waveform corresponding to vibration sense in an explosion scene in a game.

A scene vibration sense waveform may be downloaded from a backend server of an application. The type of waveform is a waveform corresponding to vibration sense in a scene of the application, or may be obtained from locally stored waveforms that are generated in the electronic device. This is not limited herein.

Further, the scene vibration sense waveform may be pre-stored in a scene vibration sense library, and the scene vibration library may be in a specific form such as a database or a folder. Waveform files in the scene vibration sense library may be added, deleted, or modified.
3. Receive the waveform from an external source. The external source may be a source for providing waveforms such as an application or a device.
4. Invoke a pre-configured waveform which is used as a template. That is, at least one waveform is pre-configured as a template, and the waveform is obtained by invoking the template. It can be understood that the waveform used as a template may be considered as a default waveform.

In this embodiment, a plurality of manners for obtaining the waveform are provided above, and all the manners can provide an existing or a configured waveform. Therefore, the user does not have to design the waveform from scratch regardless of the service scenario in which a vibration description file is to be customized, but can make an adjustment on the basis of an obtained waveform, so that it can bring great convenience for the user, and the technical threshold is greatly reduced.

S402: Obtain an adjustment instruction for the waveform.

S403: Generate the vibration description file in response to the adjustment instruction for the waveform.

Specifically, the electronic device displays an interaction interface, displays, in response to an adjustment instruction for the waveform on the interaction interface, an adjusted waveform, and generates a vibration description file of the adjusted waveform. The first interface may be a display interface, and the interaction interface is a touch screen interface. It can be understood that the first interface is displayed on a display screen of the touch display screen, and the interaction interface is also displayed on the display screen of the touch display screen, and receives an adjustment instruction through a touch layer on the touch display screen.

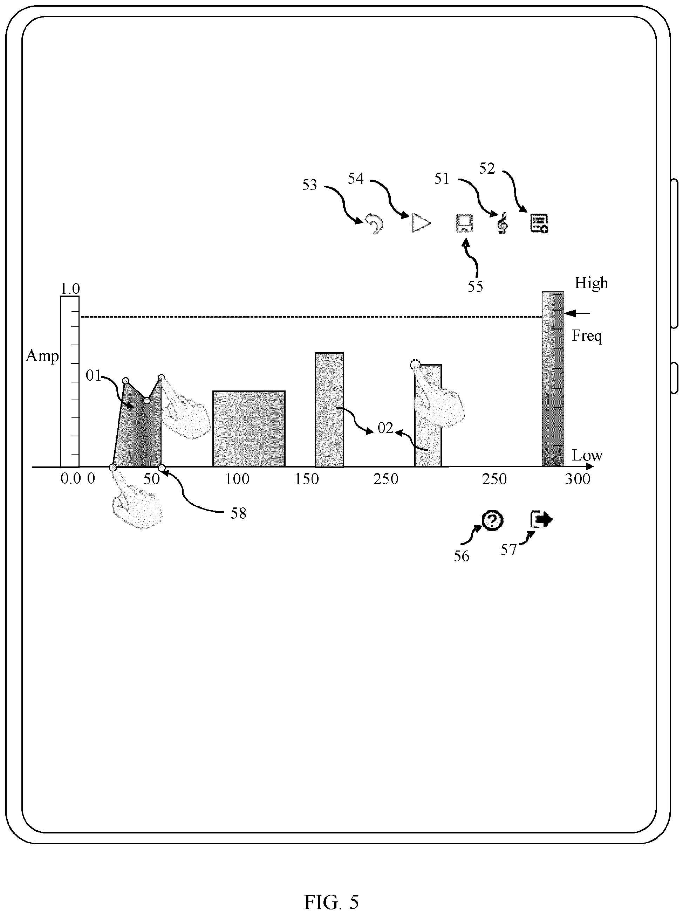

A detailed implementation of this step is described in the embodiment shown in FIG. 5.

S404: Generate the vibration description file in response to that vibration parameters of the adjusted waveform do not exceed a preset adjustment limit value. The adjustment limit value is set to protect a to-be-controlled linear motor from being damaged. That is, in a case that the user adjusts a value of a vibration parameter of a basic waveform to exceed the adjustment limit value, no response is made to the adjustment instruction.

Further, prompt information may also be displayed, and the prompt information is used for prompting that the adjustment exceeds the adjustment limit value.

Specifically, the adjustment limit value may include, but is not limited to, an amplitude limit value, a startup time limit value, and a stop time limit value.

The amplitude limit value may be determined according to a maximum displacement of the to-be-controlled linear motor. The startup time limit value and the stop time limit value may be determined according to properties of the to-be-controlled linear motor.

It can be seen that, in the flow described in this embodiment, the waveform is obtained and displayed first, the displayed waveform is further adjusted, and then the vibration description file of the adjusted waveform is generated. That is, the waveform obtained and displayed in S401 may be considered as the basic waveform, the basic waveform is adjusted to obtain a required vibration waveform, and a required vibration description file is further obtained. Compared to the prior art, no written code is required to form the vibration description file, which can lower the technical threshold for obtaining the vibration description file, and improve the obtaining efficiency.

From the perspective of the user, because the basic waveform is displayed first, the user does not have to design the waveform from scratch. Therefore, the user does not need to have a programming background or a vibration background, thereby further lowering the technical threshold for the user to customize the vibration according to scenes.

More importantly, because the technical threshold is lowered, the user can be freer to configure the vibration waveform to design vibration modes for more service scenarios, thereby expanding the vibration function and improving the user experience.

FIG. 5 shows an example of an interaction interface according to an embodiment of this application. A musical icon 51 is used for importing an audio file (an example of a multimedia file). The user may tap the musical icon 51 at an upper right corner of the interaction interface to import the audio file, and the interaction interface displays a basic waveform generated according to the imported audio file.

A file icon 52 is used for importing a waveform in a scene vibration sense library. That is, in response to a selection instruction triggered by the user through a selection operation, a waveform selected by the user from the scene vibration sense library is imported as the basic waveform to be displayed.

The file icon 52 is further used for importing a waveform received from an external source. That is, the waveform received from the external source is stored in a terminal, and in response to a selection instruction triggered by the user through a selection operation, the waveform received from the external source that is selected by the user is imported as the basic waveform to be displayed.

In addition, in a blank region of the interaction interface shown in FIG. 5, the user may choose to add a slice Slice/event Event through a pop-up dialog box by a touch and hold operation, where a newly added waveform is a default waveform, and the default waveform is a rectangular wave with a duration of 30 ms and an amplitude of 1 (normalized value), and choose the Slice/Event to be in a steady state or a transient state.

It can be understood that one of the manners for adding the basic waveform described above may be selected, or a combination thereof may be used, which is not limited in this embodiment. In this embodiment, the displayed basic waveform is referred to as Slice/Event.

In FIG. 5, a Y (vertical) axis on a left side represents an amplitude (Amplitude, also referred to as intensity Intensity, or Amp for short). A Y (vertical) axis on a right side represents a frequency (frequency, also referred to as sharpness Sharpness, or Freq for short). An X (horizontal) axis represents a duration (Time in milliseconds). The Y-axis on the left side has a range from 0 to 1 with ticks denoting intermediate values. The Y-axis on the right side represents the magnitude of the frequency in grayscale or color shades. The darker the shade is, the lower the frequency is. The lighter the shade is, the higher the frequency is.

S402 is illustrated below based on FIG. 5:
1. Display, in response to a preset operation instruction for an adjustment point on the waveform displayed on the interaction interface, the adjustment point on the waveform. Display, in response to a dragging instruction for the adjustment point in an adjustment mode for a first vibration parameter, a waveform after the first vibration parameter is adjusted, where the first vibration parameter includes an amplitude and/or a frequency.

For example, for a displayed steady state waveform 01 or a transient state waveform 02, the user touches and holds the waveform to pop up a dialog box or an option box, and chooses to add an adjustment point (referred to as a point below, and denoted by a circle) from the dialog box or option box. Display, in response to an instruction for adding a point, an added point on the waveform. It can be understood that, because the transient state waveform 02 does not involve adjustment of the envelope, a point on the transient state waveform 02 is only a top point of an upper edge. Alternatively, for the transient state waveform 02, the top point of the upper edge is the adjustment point by default, no new adjustment point can be added, and no existing adjustment point can be changed.

A process of adjusting the amplitude of the steady state waveform 01 by the user is as follows: Tap the Y-axis on the left side to trigger and enter an amplitude adjustment mode, and adjust the amplitude of the steady state waveform 01 by dragging any one point. That is, in response to a tapping operation by the user on the Y-axis on the left side, the amplitude adjustment mode is entered, and in response to a dragging instruction (that is, an instruction triggered by a dragging operation) for the point, the waveform after the amplitude is adjusted is displayed.

A process of adjusting the frequency of the steady state waveform 01 by the user is as follows: Tap the Y-axis on the right side to trigger a frequency adjustment mode, and select the frequency of the steady state waveform 01 by dragging any one point. That is, in response to a tapping operation by the user on the Y-axis on the right side, the frequency adjustment mode is entered, and in response to a dragging instruction (that is, an instruction triggered by a dragging operation) for the point, the waveform after the frequency is adjusted is displayed.

It should be noted that, in the process of adjusting the amplitude, a rightmost point on the steady state waveform 01 can only move upward or downward, and the existing frequency cannot be changed because of the current amplitude adjustment mode. That is, in the amplitude adjustment mode, left and right dragging instructions for the rightmost point on the steady state waveform 01 are not responded to.

For the steady state waveform 01, a time parameter may also be adjusted by selecting a point of the steady state waveform 01 on the X-axis to trigger and enter a time adjustment mode. In the time adjustment mode, at least two adjustment points 58 are displayed on the X-axis. A start time of the steady state waveform 01 (a start time of the waveform) is adjusted by dragging an adjustment point on the left along the X-axis to the left and right. The duration of the steady state waveform 01 is adjusted by dragging the adjustment point on the right along the X-axis to the left and right.

That is, in response to a tapping operation by the user on a point on the X-axis, the time adjustment mode is entered, and in response to an instruction for dragging the adjustment point on a time axis in the time adjustment mode, the waveform after the time is adjusted is displayed.

A process of adjusting the amplitude of the transient state waveform 02 by the user is as follows: Tap the Y-axis on the left side to trigger and enter the amplitude adjustment mode, and adjust the amplitude of the transient state waveform 02 by dragging the top point of the upper edge up and down. That is, in response to a tapping operation by the user on the Y-axis on the left side, the amplitude adjustment mode is entered, and in response to an up and down dragging instruction (that is, an instruction triggered by an up and down dragging instruction) for the point, the waveform after the amplitude is adjusted is displayed.

A process of adjusting the frequency of the transient state waveform 02 by the user is as follows: Tap the Y-axis on the right side to trigger and enter the frequency adjustment mode, and adjust the frequency of the transient state waveform 02 by dragging the top point of the upper edge from left to right. That is, in response to a tapping operation by user on the Y-axis on the right side, the frequency adjustment mode is entered, and in response to a left and right dragging instruction (that is, an instruction triggered by a left and right dragging operation) for the point, the waveform after the frequency is adjusted is displayed. 2. Display, in response to a dragging instruction for the waveform displayed on the interaction interface, a waveform after the time is adjusted.

The user drags the steady state waveform 01 along the X-axis as a whole to adjust the start time. That is, in response to a dragging instruction for the steady state waveform 01 along the X-axis, the waveform after the start time is adjusted is displayed.

The user drags the transient state waveform 02 along the X-axis as a whole to adjust the start time. That is, in response to a dragging instruction for the transient state waveform 02 along the X-axis, the waveform after the start time is adjusted is displayed.

To enhance the visibility of the adjustment, indication information corresponding to the value of the adjusted parameter is displayed on the interaction interface.

Specifically, in the displayed waveform, the grayscale or color representing the currently selected frequency is filled, and is adjusted in real time with the frequency selected by the movement of the point to visually present the currently selected frequency.

Further, in a waveform (in a steady state or a transient state) that is not in the frequency adjustment state, the grayscale or color representing the current frequency of the waveform may also be filled to visually present the current frequency of the waveform that is not in the adj ustment state. Further, in the frequency adjustment mode, an arrow is displayed near a frequency axis, pointing to the currently selected frequency to visually present the current frequency of the waveform.

It can be understood that the transient state waveform 02 is filled with only one color because there is only one frequency.

In addition to adjustment for a single waveform, in this embodiment, superposition of a plurality of waveforms is also supported. If the user selects a plurality of waveforms and drags the waveforms to a time range overlapping state, the superposition of the plurality of waveforms within an overlapping time range is triggered. That is, in response to a superimposition instruction for dragging the plurality of waveforms to the time range overlapping state, the plurality of waveforms are superimposed. For example, if a first waveform is dragged to be within a time range of a second waveform, the first waveform and the second waveform are superimposed. The plurality of waveforms are at least a part of the basic waveform described above.

The plurality of waveforms that are superimposed are not limited to events. Assuming that the waveform obtained in S401 is the first waveform, and corresponds to a first vibration event, the second waveform superimposed with the first waveform may be a waveform of the first vibration event, or may be a waveform of another vibration event, for example, a waveform of a second vibration event.

For example, a specific calculation of waveform superimposition is an amplitude value addition. Details are not described herein again. The purpose of waveform superimposition is to support the superimposition of vibration effects of a plurality of scenarios by superimposing, presenting, and expanding a variety of vibration effects, which enriches the vibration feeling of the user. It can be understood that, the waveform superimposition is not limited to be implemented on the interaction interface described above.

In addition to the adjustment operations described above, the interaction interface shown in FIG. 5 may further implement the following functions:
The dialog box or the option box that pops up through touching and holding on the waveform further includes an option to delete the adjustment point, which may be selected by the user to delete the adjustment point. Similarly, the dialog box or the option box that pops up through touching and holding on the waveform further includes an option to delete the Slice/Event, which may be selected by the user to delete the waveform.

During the adjustment, the user may tap a return control 53 to cancel the adjustment operation, and tap a playback control 54 to play the vibration triggered by the adjusted waveform, to feel the vibration effect of the adjusted waveform and assist in the adjustment. In addition, the adjusted waveform may also be saved by tapping a save control 55. Optionally, a help control 56 and an exit control 57 may also be provided on the interaction interface in FIG. 5.

The interaction interface shown in FIG. 5 can bring great convenience for the user to generate a vibration description file. It can be understood that, the controls, display manners, and the like of the interaction interface described above are examples and are not construed as a limitation. Controls, display manners, and the like that can implement the same functions may also be used for replacing the corresponding parts in FIG. 5.

It should be noted that, the vibration parameters of the vibration waveform may include, but are not limited to, an amplitude, a sharpness, a waveform type, a start time, a duration, a startup time, and a stop time. Therefore, the generated vibration description file includes values of the vibration parameters described above. The foregoing examples only illustrate the adjustment of some vibration parameters, which are considered as examples only, and are not construed as a limitation. It can be understood that, the interaction interface shown in FIG. 5 may be packaged as an application. Based on the application, the user may adjust the waveform to obtain a customized waveform based on the basic waveform in a human-machine interaction manner, and then obtain a vibration description file describing the customized waveform. The type of vibration description file may correspond to at least one service scenario. For example, the vibration description file obtained after the basic waveform is adjusted and obtained according to an audio file is stored corresponding to the audio, so that the user can customize a vibration form corresponding to the service scenario. For example, the linear motor can vibrate with the rhythm of the audio during audio playback.

During the study, the applicant found that during use of the actual products, the vibration originally designed for one or some service scenarios to improve the user experience may cause interference to other service scenarios.

For example, during audio playback, when a short message is received, the vibration with the audio playback may affect the short message service. For example, the vibration interferes with a prompt message, so that the user does not perceive the prompt message, resulting in that the user does not check the short message in time. In another example, the user opens a short message interface to check the short message, but the vibration of the linear motor interferes with the checking of the short message, which reduces the user experience.

In order to resolve the foregoing problems, the vibration description file in the foregoing embodiments is classified into a static description file and a dynamic description file.

The function of the dynamic description file is to control, in a case that an interruption event occurs during vibration of a linear motor, the vibration of the linear motor according to vibration parameters in the dynamic description file.

The interruption means that: during an execution of a program implementing a first event (for example, audio playback), when a second event (for example, a short message application) is triggered (for example, a short message is received), the program implementing the first event is stopped, a program implementing the second event is executed until the second event is completed, and then the program implementing the first event continues to be executed. Alternatively, the first event and the second event are executed simultaneously, for example, the program implementing the first event and the program implementing the second event are executed simultaneously. In short, the execution of an event is interrupted, or an event is added to be simultaneously executed with the execution of an event.

The interruption event refers to an event that interrupts execution, or an event newly added to be simultaneously executed with other events during the execution of the other events.

It can be seen that a dynamic description file may be configured for the interruption event, so that when the interruption event occurs, the vibration sense can be weakened to reduce the interference to the interruption event.

Based on the manners for obtaining the basic waveform described above, in this embodiment, the waveform received from an external source is used as the basic waveform for generating the dynamic description file. It can be understood that, the waveform received from the external source may be imported and displayed by using the interaction interface shown in FIG. 5, and a dynamic description file may be obtained after adjustment. The external source may execute the interruption event, for example, the short message application described above. That is, after an application is installed on an electronic device, the application may be pre-configured to generate a basic waveform of the dynamic description file for the user to generate the dynamic description file, thereby providing a possibility to reduce the extent to which the application is interfered by vibration during use.

Certainly, the waveform received from the external source may also be used for other purposes, but is not limited to the generation of a dynamic description file.

Correspondingly, the vibration description file generated through the basic waveform that is obtained according to characteristics of an object to which vibration is to be applied or is selected from the pre-configured scene vibration library may be used for controlling the vibration of the linear motor in a case that no interruption event occurs. In this scenario, in order to distinguish between two types of vibration description files, the latter may be referred to as a static description file.

The specific application processes of the dynamic description file and the static description file do not fall within the scope of this specification. Therefore, details are not described herein. It can be understood that, the vibration parameters described in the static description file may be the same as or different from the vibration parameters described in the dynamic description file. Further, types of the vibration parameters described by the dynamic description file are a subset of types of the vibration parameters described by the static description file. That is, because the dynamic description file is used in a case that an interruption event occurs, in combination with the foregoing application scenarios, it is possible that not all parameters of a drive waveform but only parameters that are highly correlated with vibration sense need to be adjusted. Therefore, the dynamic description file may only describe the parameters that are highly correlated with the vibration sense. Therefore, types of parameters described in the dynamic description file may be less than types of parameters described in the static description file. For example, the static description file only describes the amplitude. This manner simplifies the content of the dynamic description file, thereby reducing the cost of generating the dynamic description file.

The dynamic description file may also be visualized and adjusted to provide greater possibilities and flexibility for subsequent dynamic adjustment of the vibration of the linear motor.

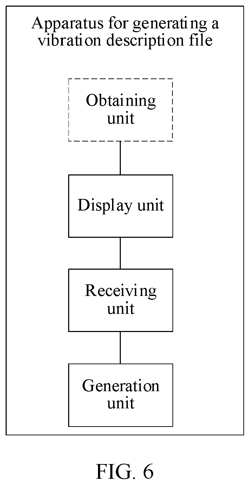

FIG. 6 shows an apparatus for generating a vibration description file according to an example useful for understanding the invention but not forming part of the present invention. The apparatus is applicable to an electronic device. The electronic device includes a linear motor. The apparatus includes: a display unit, a receiving unit, and a generation unit. Optionally, an obtaining unit may also be included.

The obtaining unit is configured to generate the waveform according to vibration characteristics of an application; or use a waveform selected from pre-configured scene vibration sense waveforms as the waveform; or receive the waveform from an external source; or invoke a pre-configured waveform which is used as a template.

The display unit is configured to present a first interface, where the first interface displays the waveform obtained by the obtaining unit. The receiving unit is configured to obtain an adjustment instruction for the waveform, and the generation unit is configured to generate the vibration description file in response to the adjustment instruction.

Optionally, that the generation unit is configured to generate the vibration description file in response to the adjustment instruction is specifically implemented as follows: generating a dynamic description file in response to an adjustment instruction for the waveform received from an external source, where the dynamic description file is used for controlling vibration of the linear motor according to vibration parameters in the dynamic description file in a case that an interruption event occurs.

Optionally, that the generation unit is configured to generate the vibration description file in response to the adjustment instruction further includes the following steps: responding to the waveform generated according to the vibration characteristics of the application; generating a static description file according to the adjustment instruction for the waveform selected from the pre-configured scene vibration sense waveforms, where the static description file is used for controlling the vibration of the linear motor according to vibration parameters in the static description file in a case that no interruption event occurs.

Optionally, types of the vibration parameters indicated by the dynamic description file are a subset of types of the vibration parameters indicated by the static description file.

Optionally, that the generation unit is configured to generate the vibration description file in response to the adjustment instruction is specifically implemented as follows: displaying, in response to an adjustment instruction for the waveform on an interaction interface, an adjusted waveform; and generating a vibration description file of the adjusted waveform.

Optionally, that the generation unit is configured to display, in response to an adjustment instruction for the waveform on an interaction interface, an adjusted waveform is specifically implemented as follows: displaying, in response to a preset operation instruction for an adjustment point on the waveform displayed on the interaction interface, the adjustment point on the waveform; and displaying, in response to a dragging instruction for the adjustment point in an adjustment mode for a first vibration parameter, a waveform after the first vibration parameter is adjusted, where the first vibration parameter includes an amplitude and/or a frequency.

Optionally, the waveform includes a steady state waveform, and the first vibration parameter further includes: a time parameter. That the generation unit is configured to display, in response to a dragging instruction for the adjustment point in an adjustment mode for a first vibration parameter, a waveform after the first vibration parameter is adjusted is specifically implemented as follows: displaying, in response to a dragging instruction for the adjustment point on a time axis in a time adjustment mode, a waveform after the time parameter is adjusted.

Optionally, that the generation unit is configured to display, in response to an adjustment instruction for the waveform on an interaction interface, an adjusted waveform is specifically implemented as follows: displaying, in response to a dragging instruction for the waveform displayed on the interaction interface, a waveform after the time parameter is adjusted. Optionally, the display unit is further configured to display indication information corresponding to a value of an adjusted parameter on the interaction interface.

Optionally, the generation unit is further configured to superimpose a plurality of waveforms in response to a superimposition instruction, and generate a vibration description file of a superimposed waveform, where the plurality of waveforms are at least a part of the waveform. Optionally, that the generation unit is configured to superimpose a plurality of waveforms in response to a superimposition instruction is specifically implemented as follows: superimposing the plurality of waveforms in response to an instruction for dragging the plurality of waveforms to a time range overlapping state.

Optionally, that the generation unit is configured to generate the vibration description file is specifically implemented as follows: generating the vibration description file in response to that vibration parameters of the adjusted waveform do not exceed a preset adjustment limit value.

In this example, in the apparatus for generating a vibration description file, no written code is required to form the vibration description file, which can lower the technical threshold for obtaining the vibration description file and improve the obtaining efficiency. Because the technical threshold is lowered, the user can be freer to customize the vibration waveform to design vibration modes for more service scenarios, thereby expanding the vibration function and improving the user experience.

Another example useful for understanding the invention further discloses a readable storage medium, storing a computer program, where the computer program, when executed by a processor, implements the method for generating a vibration description file according to the foregoing embodiments.

## Claims

1. A method for generating a vibration description file, applicable to an electronic device, wherein the electronic device comprises a linear motor and a display (194), and the method comprises:
presenting (S401), by the display of the electronic device, a first interface, wherein the first interface displays an obtained vibration waveform;
obtaining (S402), by the electronic device, an adjustment instruction for the vibration waveform;
generating, by the electronic device, an adjusted vibration waveform by applying the adjustment instruction for the vibration waveform on the obtained vibration waveform;
generating (S403), by the electronic device, the vibration description file based on the adjusted vibration waveform; and
controlling vibration of the linear motor using the vibration description file, **characterized in that** the generating (S403) the vibration description file comprises:
generating (S404) the vibration description file in response to that vibration parameters of the adjusted vibration waveform do not exceed a preset adjustment limit value.

2. The method according to claim 1, wherein the obtained vibration waveform is obtained by:
generating the vibration waveform according to vibration characteristics of an application; or
using a waveform selected from pre-configured scene vibration sense waveforms as the vibration waveform; or
receiving the vibration waveform from an external source; or
invoking a pre-configured vibration waveform which is used as a template.

3. The method according to claim 2, wherein the generating (S403) the vibration description file comprises:
generating a dynamic description file in response to the adjustment instruction for the vibration waveform received from the external source, wherein the dynamic description file is used for controlling vibration of the linear motor according to vibration parameters in the dynamic description file in a case that an interruption event occurs.

4. The method according to claim 3, wherein the generating (S403) the vibration description file further comprises:
responding to the vibration waveform generated according to the vibration characteristics of the application; or generating a static description file according to the adjustment instruction for the vibration waveform selected from the pre-configured scene vibration sense waveforms, wherein the static description file is used for controlling the vibration of the linear motor according to vibration parameters in the static description file in a case that no interruption event occurs.

5. The method according to claim 4, wherein types of the vibration parameters indicated by the dynamic description file are a subset of types of the vibration parameters indicated by the static description file.

6. The method according to any one of claims 1 to 5, wherein the generating an adjusted vibration waveform comprises:
displaying, in response to an adjustment instruction for the vibration waveform on an interaction interface, the adjusted vibration waveform.

7. The method according to claim 6, wherein the displaying, in response to an adjustment instruction for the vibration waveform on an interaction interface, the adjusted vibration waveform comprises:
displaying, in response to a preset operation instruction for an adjustment point on the vibration waveform displayed on the interaction interface, the adjustment point on the vibration waveform; and
displaying, in response to a dragging instruction for the adjustment point in an adjustment mode for a first vibration parameter, a vibration waveform after the first vibration parameter is adjusted, wherein the first vibration parameter comprises an amplitude and/or a frequency.

8. The method according to claim 7, wherein the vibration waveform comprises a steady state waveform;
the first vibration parameter further comprises: a time parameter; and
the displaying, in response to a dragging instruction for the adjustment point in an adjustment mode for a first vibration parameter, a vibration waveform after the first vibration parameter is adjusted comprises:
displaying, in response to a dragging instruction for the adjustment point on a time axis in a time adjustment mode, a vibration waveform after the time parameter is adjusted.

9. The method according to claim 6, wherein the displaying, in response to an adjustment instruction for the vibration waveform on an interaction interface, the adjusted vibration waveform comprises:
displaying, in response to a dragging instruction for the vibration waveform displayed on the interaction interface, a vibration waveform after the time parameter is adjusted.

10. The method according to claim 6, further comprising:
displaying indication information corresponding to a value of an adjusted parameter on the interaction interface.

11. The method according to any one of claims 1 to 5, wherein the generating an adjusted vibration waveform comprises:
superimposing a plurality of waveforms in response to a superimposition instruction, and generating the adjusted vibration waveform of a superimposed waveform, wherein the plurality of waveforms are at least a part of the vibration waveform.

12. The method according to claim 11, wherein the superimposition instruction comprises:
an instruction for dragging the plurality of waveforms to a time range overlapping state.

13. An electronic device, comprising:
one or more processors; a linear motor;
a display (194); and
a memory, storing a program, wherein
the electronic device is configured to carry out the method for generating a vibration description file according to any one of claims 1 to 12.

## Patentansprüche

1. Verfahren zum Erzeugen einer Vibrationsbeschreibungsdatei, die auf eine elektronische Vorrichtung anwendbar ist, wobei die elektronische Vorrichtung einen Linearmotor und eine Anzeige (194) umfasst, und das Verfahren umfasst:
Darstellen (S401), durch die Anzeige der elektronischen Vorrichtung, einer ersten Schnittstelle, wobei die erste Schnittstelle eine erhaltene Vibrationswellenform anzeigt;
Erhalten (S402), durch die elektronische Vorrichtung, einer Anpassungsanweisung für die Vibrationswellenform;
Erzeugen, durch die elektronische Vorrichtung, einer angepassten Vibrationswellenform durch Anwenden der Anpassungsanweisung für die Vibrationswellenform auf die erhaltene Vibrationswellenform;
Erzeugen (S403), durch die elektronische Vorrichtung, der Vibrationsbeschreibungsdatei basierend auf der angepassten Vibrationswellenform; und
Steuern einer Vibration des Linearmotors unter Verwendung der Vibrationsbeschreibungsdatei, **dadurch gekennzeichnet, dass** das Erzeugen (S403) der Vibrationsbeschreibungsdatei umfasst:
Erzeugen (S404) der Vibrationsbeschreibungsdatei als Reaktion darauf, dass Vibrationsparameter der angepassten Vibrationswellenform einen voreingestellten Anpassungsgrenzwert nicht überschreiten.

2. Verfahren nach Anspruch 1, wobei die erhaltene Vibrationswellenform erhalten wird durch:
Erzeugen der Vibrationswellenform gemäß Vibrationskennzeichen einer Anwendung; oder
Verwenden einer Wellenform, die aus vorkonfigurierten Szenenvibrationsempfindungswellenformen ausgewählt wird, als die Vibrationswellenform; oder
Empfangen der Vibrationswellenform von einer externen Quelle; oder
Aufrufen einer vorkonfigurierten Vibrationswellenform, die als eine Vorlage verwendet wird.

3. Verfahren nach Anspruch 2, wobei das Erzeugen (S403) der Vibrationsbeschreibungsdatei umfasst:
Erzeugen einer dynamischen Beschreibungsdatei als Reaktion auf die Anpassungsanweisung für die Vibrationswellenform, die von der externen Quelle empfangen wird, wobei die dynamische Beschreibungsdatei zum Steuern der Vibration des Linearmotors gemäß Vibrationsparametern in der dynamischen Beschreibungsdatei in einem Fall, dass ein Unterbrechungsereignis auftritt, verwendet wird.

4. Verfahren nach Anspruch 3, wobei das Erzeugen (S403) der Vibrationsbeschreibungsdatei ferner umfasst:
Reagieren auf die Vibrationswellenform, die gemäß den Vibrationskennzeichen der Anwendung erzeugt wird; oder Erzeugen einer statischen Beschreibungsdatei gemäß der Anpassungsanweisung für die Vibrationswellenform, die aus den vorkonfigurierten Szenenvibrationsempfindungswellenformen ausgewählt wird, wobei die statische Beschreibungsdatei zum Steuern der Vibration des Linearmotors gemäß Vibrationsparametern in der statischen Beschreibungsdatei in einem Fall, dass kein Unterbrechungsereignis auftritt, verwendet wird.

5. Verfahren nach Anspruch 4, wobei Arten der Vibrationsparameter, die durch die dynamische Beschreibungsdatei angegeben werden, eine Untermenge von Arten der Vibrationsparameter, die durch die statische Beschreibungsdatei angegeben werden, sind.

6. Verfahren nach einem der Ansprüche 1 bis 5, wobei das Erzeugen einer angepassten Vibrationswellenform umfasst:
Anzeigen, als Reaktion auf eine Anpassungsanweisung für die Vibrationswellenform auf einer Interaktionsschnittstelle, der angepassten Vibrationswellenform.

7. Verfahren nach Anspruch 6, wobei das Anzeigen, als Reaktion auf eine Anpassungsanweisung für die Vibrationswellenform auf einer Interaktionsschnittstelle, der angepassten Vibrationswellenform umfasst:
Anzeigen, als Reaktion auf eine voreingestellte Betriebsanweisung für einen Anpassungspunkt auf der Vibrationswellenform, die auf der Interaktionsschnittstelle angezeigt wird, des Anpassungspunkts auf der Vibrationswellenform; und
und Anzeigen, als Reaktion auf eine Ziehanweisung für den Anpassungspunkt in einem Anpassungsmodus für einen ersten Vibrationsparameter, einer Vibrationswellenform, nachdem der erste Vibrationsparameter angepasst ist, wobei der erste Vibrationsparameter eine Amplitude und/oder eine Frequenz umfasst.

8. Verfahren nach Anspruch 7, wobei die Vibrationswellenform eine stationäre Wellenform umfasst;
der erste Vibrationsparameter ferner umfasst: einen Zeitparameter; und
das Anzeigen, als Reaktion auf eine Ziehanweisung für den Anpassungspunkt in einem Anpassungsmodus für einen ersten Vibrationsparameter, einer Vibrationswellenform, nachdem der erste Vibrationsparameter angepasst ist, umfasst:
Anzeigen, als Reaktion auf eine Ziehanweisung für den Anpassungspunkt auf einer Zeitachse in einem Zeitanpassungsmodus, einer Vibrationswellenform, nachdem der Zeitparameter angepasst ist.

9. Verfahren nach Anspruch 6, wobei das Anzeigen, als Reaktion auf eine Anpassungsanweisung für die Vibrationswellenform auf einer Interaktionsschnittstelle, der angepassten Vibrationswellenform umfasst:
Anzeigen, als Reaktion auf eine Ziehanweisung für die Vibrationswellenform, die auf der Interaktionsschnittstelle angezeigt wird, einer Vibrationswellenform, nachdem der Zeitparameter angepasst ist.

10. Verfahren nach Anspruch 6, ferner umfassend:
Anzeigen von Angabeinformationen, die einem Wert eines angepassten Parameters entsprechen, auf der Interaktionsschnittstelle.

11. Verfahren nach einem der Ansprüche 1 bis 5, wobei das Erzeugen einer angepassten Vibrationswellenform umfasst:
Überlagern einer Vielzahl von Wellenformen als Reaktion auf eine Überlagerungsanweisung und Erzeugen der angepassten Vibrationswellenform einer überlagerten Wellenform, wobei die Vielzahl von Wellenformen mindestens ein Teil der Vibrationswellenform sind.

12. Verfahren nach Anspruch 11, wobei die Überlagerungsanweisung umfasst:
eine Anweisung zum Ziehen der Vielzahl von Wellenformen in einen einen Zeitbereich überlappenden Zustand.

13. Elektronische Vorrichtung, umfassend:
einen oder mehrere Prozessoren; einen Linearmotor;
eine Anzeige (194); und
einen Speicher, der ein Programm speichert, wobei
die elektronische Vorrichtung konfiguriert ist, um das Verfahren zum Erzeugen einer Vibrationsbeschreibungsdatei nach einem der Ansprüche 1 bis 12 auszuführen.

## Revendications

1. Procédé de génération d'un fichier de description des vibrations, applicable à un dispositif électronique, dans lequel le dispositif électronique comprend un moteur linéaire et une unité d'affichage (194), et le procédé comprend :
la présentation (S401), par l'unité d'affichage du dispositif électronique, d'une première interface, dans lequel la première interface affiche une forme d'onde vibratoire obtenue ;
l'obtention (S402), par le dispositif électronique, une instruction d'ajustement pour la forme d'onde vibratoire ;
la génération, par le dispositif électronique, d'une forme d'onde vibratoire ajustée en appliquant l'instruction d'ajustement de la forme d'onde vibratoire à la forme d'onde vibratoire obtenue ;
la génération (S403), par le dispositif électronique, du fichier de description des vibrations sur la base de la forme d'onde vibratoire ajustée ; et
la commande de la vibration du moteur linéaire à l'aide du fichier de description des vibrations, **caractérisé en ce que** la génération (S403) du fichier de description des vibrations comprend :
la génération (S404) du fichier de description des vibrations en réponse au fait que des paramètres vibratoires de la forme d'onde vibratoire ajustée ne dépassent pas une valeur limite d'ajustement prédéfinie.

2. Procédé selon la revendication 1, dans lequel la forme d'onde vibratoire obtenue est obtenue par :
génération de la forme d'onde vibratoire selon des caractéristiques vibratoires d'une application ; ou
utilisation d'une forme d'onde sélectionnée parmi des formes d'onde de détection de vibration de scène pré-configurées en tant que forme d'onde vibratoire ; ou
réception de la forme d'onde vibratoire en provenance d'une source externe ; ou
invocation d'une forme d'onde vibratoire pré-configurée qui est utilisée en tant que modèle.

3. Procédé selon la revendication 2, dans lequel la génération (S403) du fichier de description des vibrations comprend :
la génération d'un fichier de description dynamique en réponse à l'instruction d'ajustement de la forme d'onde vibratoire reçue en provenance de la source externe, dans lequel le fichier de description dynamique est utilisé pour commander la vibration du moteur linéaire selon des paramètres vibratoires dans le fichier de description dynamique dans le cas où un événement d'interruption se produit.

4. Procédé selon la revendication 3, dans lequel la génération (S403) du fichier de description des vibrations comprend en outre :
le fait de répondre à la forme d'onde vibratoire générée selon les caractéristiques vibratoires de l'application ; ou la génération d'un fichier de description statique selon l'instruction d'ajustement pour la forme d'onde vibratoire sélectionnée parmi les formes d'onde de détection de vibration de scène pré-configurées, dans lequel le fichier de description statique est utilisé pour commander la vibration du moteur linéaire selon des paramètres vibratoires dans le fichier de description statique dans le cas où aucun événement d'interruption ne se produit.

5. Procédé selon la revendication 4, dans lequel les types de paramètres vibratoires indiqués par le fichier de description dynamique sont un sous-ensemble des types de paramètres vibratoires indiqués par le fichier de description statique.

6. Procédé selon l'une quelconque des revendications 1 à 5, dans lequel la génération d'une forme d'onde vibratoire ajustée comprend :
l'affichage, en réponse à une instruction d'ajustement de la forme d'onde vibratoire sur une interface d'interaction, de la forme d'onde vibratoire ajustée.

7. Procédé selon la revendication 6, dans lequel l'affichage, en réponse à une instruction d'ajustement de la forme d'onde vibratoire sur une interface d'interaction, de la forme d'onde vibratoire ajustée comprend :
l'affichage, en réponse à une instruction d'opération prédéfinie pour un point d'ajustement sur la forme d'onde vibratoire affichée sur l'interface d'interaction, du point d'ajustement sur la forme d'onde vibratoire ; et
l'affichage, en réponse à une instruction de déplacement pour le point d'ajustement dans un mode d'ajustement pour un premier paramètre vibratoire, d'une forme d'onde vibratoires après l'ajustement du premier paramètre vibratoire, dans lequel le premier paramètre vibratoire comprend une amplitude et/ou une fréquence.

8. Procédé selon la revendication 7, dans lequel la forme d'onde vibratoire comprend une forme d'onde en régime permanent ;
le premier paramètre vibratoire comprend en outre : un paramètre temporel ; et
l'affichage, en réponse à une instruction de déplacement du point d'ajustement dans un mode d'ajustement d'un premier paramètre vibratoire, d'une forme d'onde vibratoires après l'ajustement du premier paramètre vibratoire comprend :
l'affichage, en réponse à une instruction de déplacement du point d'ajustement sur un axe temporel dans un mode d'ajustement temporel, d'une forme d'onde vibratoire après l'ajustement du paramètre temporel.

9. Procédé selon la revendication 6, dans lequel l'affichage, en réponse à une instruction d'ajustement de la forme d'onde vibratoire sur une interface d'interaction, de la forme d'onde vibratoire ajustée comprend :
l'affichage, en réponse à une instruction de déplacement de la forme d'onde vibratoire affichée sur l'interface d'interaction, d'une forme d'onde vibratoire après l'ajustement du paramètre temporel.

10. Procédé selon la revendication 6, comprenant en outre :
l'affichage, sur l'interface d'interaction, d'informations d'indication correspondant à une valeur d'un paramètre ajusté.

11. Procédé selon l'une quelconque des revendications 1 à 5, dans lequel la génération d'une forme d'onde vibratoire ajustée comprend :
la superposition d'une pluralité de formes d'onde en réponse à une instruction de superposition, et la génération de la forme d'onde vibratoire ajustée d'une forme d'onde superposée, dans lequel la pluralité de formes d'onde constitue au moins une partie de la forme d'onde vibratoire.

12. Procédé selon la revendication 11, dans lequel l'instruction de superposition comprend :
une instruction pour déplacer la pluralité de formes d'onde vers un état de chevauchement des plages temporelles.

13. Dispositif électronique, comprenant :
un ou plusieurs processeurs ; un moteur linéaire ;
une unité d'affichage (194) ; et
une mémoire, stockant un programme, dans lequel le dispositif électronique est configuré pour mettre en oeuvre le procédé de génération d'un fichier de description des vibrations selon l'une des revendications 1 à 12.
